# EUROPÄISCHE PATENTSCHRIFT

(11) **EP 1 239 510 B1**
(45) Veröffentlichungstag und Bekanntmachung des Hinweises auf die Patenterteilung: **01.08.2007**
(21) Anmeldenummer: 02004543.1
(22) Anmeldetag: 27.02.2002
(51) Int. Cl.: H01J 37/317, H01J 37/147, G03F 7/20

(54) **Teilchenoptische Linsenanordnung und Verfahren unter Einsatz einer solchen Linsenanordnung**
Particle optical lensassembly and method using such a lens assembly
Assemblage de lentilles optiques à particules et méthode utilisante un tel assemblage de lentilles

(30) Priorität: 01.03.2001 DE 10109965
(43) Veröffentlichungstag der Anmeldung: 11.09.2002
(73) Patentinhaber: Carl Zeiss SMT AG, 73447 Oberkochen (DE)
(72) Erfinder: Weickenmeier, Andreas, Dr., 73431 Aalen (DE)
(74) Vertreter: Schorr, Frank Jürgen

(56) Entgegenhaltungen:
- US-A- 4 243 866
- US-A- 5 747 819
- US-A- 5 850 083
- US-A- 5 973 332
- US-A- 5 973 333
- PATENT ABSTRACTS OF JAPAN vol. 1999, no. 04, 30. April 1999 (1999-04-30) & JP 11 025896 A (NIKON CORP), 29. Januar 1999 (1999-01-29) & US 6 060 711 A 9. Mai 2000 (2000-05-09)

## Beschreibung

Die Erfindung betrifft eine teilchenoptische Linsenanordnung, insbesondere zur teilchenoptischen Abbildung eines in einer Objektfläche anordenbaren abzubildenden Objekts in eine Bildfläche, sowie ein Verfahren, bei dem eine solche Linsenanordnung zum Einsatz kommt, insbesondere ein Verfahren zur Herstellung eines Bauelements mit einem fotolithografischen Schritt. Insbesondere ist die Linsenanordnung zum Einsatz in einem Elektronenstrahl-Projektionslithografiesystem sowie zum Einsatz in einem Verfahren zur Herstellung eines Bauelements mittels Elektronstrahl-Projektionslithografie vorgesehen.

Als ein Verfahren, das mit einem Elektronenstrahl zur Abbildung und Belichtung einer strahlungsempfindlichen Schicht arbeitet, ist das sogenannte SCALPEL-Verfahren (Scattering with Angular Limitation in "Projection Electron-beam Lithography") bekannt. Dieses Verfahren ist beschrieben in dem Weisbuch "SCALPEL: A Projection Electron-Beam Approach to Sub-Optical Lithography", Technology Review, Dezember 1999, von J. A. Liddle, Lloyd R. Harriott, A.E. Novembre und W. K. Waskiewicz, Bell Laboratories, Lucent Technologies, 600 Mountain Avenue, Murray Hill, New Jersey 07974, USA. Weiterhin betreffen die Patentdokumente US 5 079 112, US 130 213, US 5 260 151, US 5 376 505, US 5 258 246, US 5 316 879 sowie EP 0 953 876 A2 und EP 0 969 326 A2 das SCALPEL-Verfahren.

Eine Linsenanordnung gemäß des Oberbegriffs des unabhängigen Anspruchs 1 ist aus den Dokumenten US 5, 973, 332 und US 4,243,866 bekannt. Eine weitere Linsenanordnung, bei der jedoch keine Zwischenbildabbildung stattfindet, ist aus der US 5,973,333 bekannt. Bei den Dokumenten US 5,973,333 und US 5,973,332 dient die Ablenklinsenanordnung zur Korrektur eines Astigmatismus und weist daher ein ablenkend wirkendes Feld mit Axialsymmetrie auf.

Aus dem Dokument US 5,850,083 ist ein Elektronenstrahl-Projektionslithographiesystem mit dynamischer Fokus- und Koma-Korrektur bekannt.

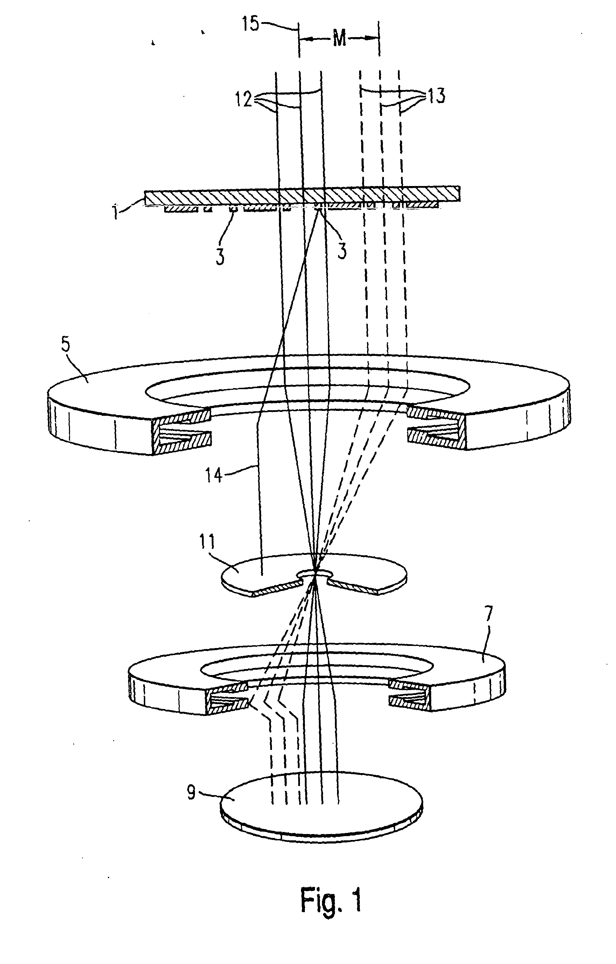

Eine herkömmliche hierfür einsetzbare abbildende Linsenanordnung mit zwei fokussierenden Linsen wird nachfolgend unter Bezugnahme auf Figur 1 erläutert.

In Figur 1 ist schematisch ein Maskenträger 1 dargestellt, welcher ein Objekt, nämlich als Maske ausgebildete abzubildende Strukturen 3 derart trägt, dass diese in einer Brennebene einer fokussierenden Magnetlinse 5 angeordnet sind, d.h. von der Magnetlinse einen Abstand aufweisen, der der Brennweite der Magnetlinse entspricht.

Die Linse 5 bildet die Objektebene mit dem abzubildenden Muster 3 nach unendlich ab, und es ist eine weitere Magnetlinse 7 vorgesehen, welche das von der Linse 5 abgebildete Muster auf eine Substratoberfläche 9 abbildet, welche von der Linse 7 einen Abstand aufweist, der deren Brennweite entspricht. Zwischen den beiden Linsen 5 und 7 ist eine Lochblende 11 vorgesehen, welche von der Linse 5 einen Abstand aufweist, der deren Brennweite entspricht, und welche von der Linse 7 einen Abstand aufweist, der der Brennweite der Linse 7 entspricht. Teilchenstrahlen 12, 13, welche die Maske außerhalb der abzubildenden Strukturen 3 durchsetzen, durchsetzen die Maske im Wesentlichen geradlinig derart, dass sie durch einen sogenannten "Crossover"-Punkt laufen, der im Zentrum der Lochblende 11 angeordnet ist, so dass diese Strahlen auf die Substratoberfläche 9 abgebildet werden. Die abzubildenden Strukturen 3 sind mittels eines die Elektronen vergleichsweise stark streuenden Materials auf dem Maskenträger 1 definiert, so dass Strahlen, die auf eine solche stärker streuende Struktur 3 treffen, von ihrer ursprünglichen Bewegungsrichtung abgelenkt werden, wie dies in Figur 1 für einen Strahl 14 dargestellt ist. Dieser kann dann von der Linse 5 nicht auf den Crossover-Punkt in der Lochblende 11 abgelenkt werden, so dass er von der Lochblende 11 absorbiert und damit auch nicht auf das Substrat 9 abgebildet wird.

Zur Abbildung der Maske 3 auf das Substrat 9 muss nicht die gesamte Maske auf einmal teilchenoptisch beleuchtet werden, sondern es ist auch möglich, zu einem jeden Zeitpunkt lediglich ein Teilfeld der Maske zu beleuchten und dieses Teilfeld scannend über die Maskenfläche zu bewegen. In Figur 1 ist mit Zentral- und Randstrahlen 12 ein Teilfeld angedeutet, welches zentral auf einer optischen Achse 15 der Linsen 5 und 7 angeordnet ist, und mit 13 sind Zentral- und Randstrahlen eines Teilfelds angedeutet, welches in der Maskenebene um eine Strecke M versetzt zu der optischen Achse 15 angeordnet ist.

Bei der vorangehend erläuterten Linsenanordnung hat sich herausgestellt, dass höheren Anforderungen genügende Abbildungscharakteristiken insbesondere für Teilfelder, welche aus der optischen Achse ausgelenkt sind, nicht zu erreichen sind.

Es ist eine Aufgabe der vorliegenden Erfindung, eine teilchenoptisch abbildende Linsenanordnung vorzuschlagen, welche eine Reduzierung von Abbildungsfehlern ermöglicht.

Insbesondere ist es eine Aufgabe der Erfindung, eine Linsenanordnung vorzuschlagen, welche die Reduzierung von Abbildungsfehlern für Teilchenstrahlen ermöglicht, die außerhalb einer optischen Achse von Komponenten der Linsenanordnung verlaufen.

Ferner ist es eine Aufgabe der Erfindung, ein Verfahren zur Herstellung miniaturisierter Bauelemente vorzuschlagen, welches eine erhöhte Präzision bei der Fertigung des Bauelements ermöglicht.

Diese Aufgabe wird in einer Linsenanordnung mit den Merkmalen des Oberbegriffs des unabhängigen Anspruchs 1 durch die Merkmale des kennzeichnenden Teils des unabhängigen Anspruchs 1 gelöst. Vorteilhafte Weiterbildungen finden sich in den Unteransprüchen.

Gemäß einem ersten Aspekt der Erfindung ist eine Linsenanordnung zur teilchenoptischen Abbildung eines in einer Objektfläche anordenbaren abzubildenden Objekts in eine Bildfläche vorgesehen, wobei die Linsenanordnung eine erste und eine zweite Fokussierlinseneinrichtung und eine Ablenklinseneinrichtung umfasst. Hierbei können die Objektfläche und die Bildfläche zunächst eine durch die Abbildung vermittelte beliebige Gestalt aufweisen, jedoch wird in der Praxis eine Annäherung wenigstens einer der Flächen an eine ebene Gestalt angestrebt werden, um zunächst eine einfache Gestaltung des Objekts oder/und der Bildfläche zu ermöglichen und dann Abbildungsfehler zu reduzieren, die unter anderem daraus entstehen, dass das Objekt nicht exakt in der vorgesehenen Objektfläche bzw. ein zu belichtendes Substrat nicht exakt in der vorgesehenen Objektfläche angeordnet ist.

Die erste Fokussierlinseneinrichtung stellt ein Feld bereit, welches auf die abbildenden Teilchen fokussierend wirkt, so dass wenigstens ein Teilfeld der Objektfläche in ein Teilfeld einer Zwischenbildfläche der Linsenanordnung abgebildet wird. Auch die zweite Fokussierlinseneinrichtung stellt ein fokussierend wirkendes Feld bereit, und zwar zur Abbildung wenigstens des Teilfelds der Zwischenbildfläche in ein Teilfeld der Bildfläche.

Zur Reduzierung von Abbildungsfehlern der ersten und/oder zweiten Fokussierlinseneinrichtung weist die Linsenanordnung eine Ablenklinseneinrichtung zur Bereitstellung eines auf die abbildenden Teilchen ablenkend wirkenden Feldes im Bereich der Zwischenbildfläche auf. Das ablenkend wirkende Feld der Ablenklinseneinrichtung führt zu einem Verkippen des Zwischenbildes bevor es durch die zweite Fokussierlinseneinrichtung auf die Bildfläche abgebildet wird. Es können also mit der Ablenklinseneinrichtung Abbildungsfehler, die zu einem Verkippen der Bildfläche relativ zu einer Soll-Bildfläche führen, kompensiert werden. Insbesondere sind dies Bildfehler, welche als Bildfeldwölbung bezeichnet werden.

Unter einem fokussierend wirkenden Feld ist in diesem Zusammenhang ein Feld zu verstehen, welches einen geeignet gewählten Zentralstrahl im Wesentlichen nicht ablenkt und welches mit zunehmend größerem Abstand von dem Zentralstrahl und parallel zu diesem verlaufende dezentrale Strahlen zu dem Zentralstrahl hin beugt, wobei auch der Winkel, mit dem die dezentralen Strahlen zu dem Zentralstrahl hin gebeugt werden, mit zunehmendem Abstand des gebeugten Strahls von dem Zentralstrahl größer wird. Diese fokussierende Wirkung muss zu einem gegebenen Zeitpunkt nicht in dem gesamten Wirkungsbereich der Felder der ersten bzw. zweiten Fokussierlinseneinrichtung erfüllt sein, es genügt vielmehr, dass ein Teilbereich der Felder der Fokussierlinseneinrichtung auf die diesen Teilbereich durchlaufenden Teilchen eine solche fokussierende Wirkung aufweist. Die Wirkung der Fokussierlinseneinrichtung auf die abbildenden Teilchen ist damit vergleichbar zu der Wirkung einer Konvexlinse in der Lichtoptik.

Vorzugsweise stellt die erste oder/und zweite Fokussierlinseneinrichtung ein Feld bereit, welches ein bezüglich einem solchen Zentralstrahl eines Strahlenbündels im Wesentlichen achssymetrisch ausgebildetes magnetisches oder/und elektrisches Feld umfasst. Alternativ oder ergänzend hierzu kann die erste oder/und zweite Fokussierlinseneinrichtung zur Erzielung der fokussierenden Wirkung zwei oder drei mit axialem Abstand voneinander angeordnete Feldanordnungen aufweisen, wobei die beiden Feldanordnungen Dipol- oder/und Quadropol-Feldanordnungen oder Kombinationen hiervon umfassen können und zusammen die fokussierende Wirkung aufweisen. Allgemein kann durch mehrere in Strahlrichtung hintereinander angeordnete Feldanordnungen, die selbst nicht nicht-rotationssymmetrische Felder erzeugen, insgesamt eine Linsenwirkung erreicht werden, die der einer Rundlinse entspricht.

Das ablenkend wirkende Feld der Ablenklinseneinrichtung lenkt dieses durchlaufende Teilchen in im Wesentlichen gleiche Richtung ab, weshalb das Feld der Ablenklinseneinrichtung insbesondere keine Axialsymmetrie aufweist. Vorzugsweise weist das Feld der Ablenklinseneinrichtung Spiegelsymmetrie zu einer Ebene auf, in welcher sich ein Zentralstrahl eines Strahlenbündels der abbildenden Teilchen erstreckt. Insbesondere ist das Feld der Ablenklinseneinrichtung ein magnetisches oder/und elektrisches Dipolfeld, das quer zu einer Ausbreitungsrichtung der abbildenden Teilchen orientiert ist. Das Feld der Ablenklinseneinrichtung hat auf die abbildenden Teilchen somit eine Wirkung, die mit der Wirkung einer Keillinse in der Lichtoptik vergleichbar ist.

Das Feld der Ablenklinseneinrichtung ist dabei in einem gewissen sich aus der Zwischenbildfläche heraus erstreckenden Bereich um die Zwischenbildfläche wirksam, d.h. der Fläche, in die die Objektfläche durch die erste Fokussierlinseneinrichtung abgebildet wird.

Die Zwischenbildfläche hat dabei die Eigenschaft, dass Teilchenstrahlen, welche die Objektfläche von einem Ort, allerdings unter verschiedenen Winkeln verlassen, die Zwischenbildfläche an im Wesentlichen einem gemeinsamen Ort mit ebenfalls unterschiedlichen Winkeln durchsetzen, wobei Strahlen, die von verschiedenen Orten der Objektfläche herrühren, auch die Zwischenbildfläche an verschiedenen Orten durchsetzen.

Die Zwischenbildfläche der ersten Fokussierlinseneinrichtung unterscheidet sich damit von der Beugungsfläche der ersten Fokussierlinseneinrichtung, welche zwischen der Zwischenbildebene und der ersten Fokussierlinseneinrichtung selbst angeordnet ist. Die Beugungsfläche weist nämlich die Eigenschaft auf, dass sie von Strahlen, die die Objektfläche von verschiedenen Orten, allerdings unter gleichem Winkel verlassen, an gleichen Orten, allerdings unter verschiedenen Winkeln durchsetzt wird. Hierbei durchsetzen Strahlen, die die Objektfläche unter verschiedenen Winkeln verlassen, die Beugungsfläche auch an verschiedenen Orten.

Eine der zweiten Fokussierlinseneinrichtung zugeordnete Beugungsfläche ist ferner zwischen der Zwischenbildebene und der zweiten Fokussierlinseneinrichtung angeordnet. In dieser zweiten Beugungsfläche treffen sich Strahlen, die die Bildfläche unter gleichen Winkeln treffen, an einem gemeinsamen Ort, allerdings unter verschiedenen Winkeln. Eine Beugungsfläche wird üblicherweise auch als Fourier-Fläche bezeichnet.

In der Beugungsfläche der ersten oder/und zweiten Fokussierlinseneinrichtung ist vorzugsweise eine Blende vorgesehen, welche Strahlen absorbiert, die die Objektfläche unter einem Winkel durchsetzen, der einen vorbestimmten Winkel übersteigt.

Vorzugsweise ist die Linsenanordnung zur Abbildung eines Teilfelds der Objektfläche auf die Bildfläche vorgesehen, wobei der Ort des Teilfelds auf ebenfalls ein Teilfeld der Objektfläche variabel einstellbar ist. Insbesondere ist hierbei ein Abstand des Teilfeldes von einer vorgegebenen Achse einstellbar, welche beispielsweise eine zentrale optische Achse der ersten oder/und zweiten Fokussierlinseneinrichtung umfasst. Es zeigt sich hierbei, dass die Ablenklinseneinrichtung besonders dazu geeignet ist, Effekte der Bildfeldwölbung, welche durch Abbildungsfehler der ersten oder/und zweiten Fokussierlinseneinrichtung hervorgerufen werden, zu kompensieren. Hierzu wird eine Stärke des Feldes der Ablenklinseneinrichtung vorzugsweise derart eingestellt, dass es sich proportional zu dem Abstand des Teilfeldes von der vorgegebenen Achse ändert. Die Ablenklinseneinrichtung führt dabei zu einem Kippen des in die Bildfläche abgebildeten Teilfelds und kann insbesondere derart eingestellt werden, dass die Bildfläche im Bereich des gerade abgebildeten Teilfelds eine in etwa eben ausgebildete Gestalt hat und somit zeitlich nacheinander sämtliche Teilfelder einer ebenen Objektfläche in im Wesentlichen eine ebene Bildfläche abgebildet werden können.

Hierbei ist insbesondere auch vorgesehen, dass die Stärke der Felder der ersten oder/und zweiten Fokussierlinseneinrichtung mit einer quadratischen Abhängigkeit von dem Abstand des Teilfeldes von der vorgegebenen Achse geändert wird, wodurch ein mit einer Bildfeldwölbung einhergehender Fokusfehler derart kompensiert werden kann, dass die Bilder einer ebenen Objektfläche auch weitgehend in einer ebenen Bildfläche scharf abgebildet sind.

Unter einem zweiten Aspekt sieht die Erfindung ein Verfahren zur Herstellung eines Bauelements vor, wobei es sich vorzugsweise um stark miniaturisierte Bauelemente, wie etwa mikromechanische Strukturen oder integrierte Schaltungen handelt. Im Fall der integrierten Schaltung enthält eine Maske ein Schaltungsmuster, das einer einzelnen Schicht der auf einem geeigneten Substrat, beispielsweise einem Silizium-Wafer, auszubildenden Schaltung entspricht. Zur Abbildung des Musters auf einen Zielbereich (englisch "Die") des Substrats wird letzteres zunächst mit einer strahlungsempfindlichen Schicht ("resist") bedeckt. Sodann wird die strahlungsempfindliche Schicht exponiert bzw. belichtet, indem das Muster der Maske mittels geladener Teilchen; beispielsweise Elektronen oder Ionen, auf die strahlungsempfindliche Schicht abgebildet wird. Die strahlungsempfindliche Schicht wird daraufhin entwickelt, und es werden entweder die belichteten bzw. exponierten oder die unbelichteten bzw. nicht exponierten Bereiche der belichteten Schicht abgetragen. Die verbleibende Struktur der strahlungsempfindlichen Schicht dient dann als Maske in beispielsweise einem Ätzschritt, einem Ionenimplantationsschritt, einem Materialabscheidungsschritt oder ähnlichem.

Erfindungsgemäß ist hierbei vorgesehen, in einem fotolithografischen Schritt des Verfahrens ein durch eine Maske definiertes Muster mittels der vorangehend beschriebenen Linsenanordnung auf ein teilchenempfindliches Substrat abzubilden.

Im Folgenden werden Ausführungsbeispiele der Erfindung anhand von Zeichnungen näher erläutert. Hierbei zeigt:
- Figur 1: eine Linsenanordnung gemäß dem Stand der Technik;
- Figur 2: einen schematischen Aufbau einer erfindungs-gemäßen Linsenanordnung sowie einen schematischen Strahlengang hierdurch,
- Figur 3: verschiedene Wicklungstypen einer in Figur 2 gezeigten Ablenklinseneinrichtung,
- Figur 4: verschiedene Anordnungen von Stromleiterwindungen der in Figur 2 gezeigten Ablenklinseneinrichtung am Umfang eines Ferritrings,
- Figur 5: eine weitere schematische Darstellung des Strahlengangs durch die in Figur 2 gezeigte Linsenanordnung und
- Figur 6: eine vergrößerte Darstellung eines Teils der Figur 5 in der Nähe einer Bildfläche der Linsenanordnung, und
- Figur 7: mehrere Darstellungen zur Erläuterung der Bildfehler reduzierenden Wirkung der erfindungsgemäßen Linsenanordnung.

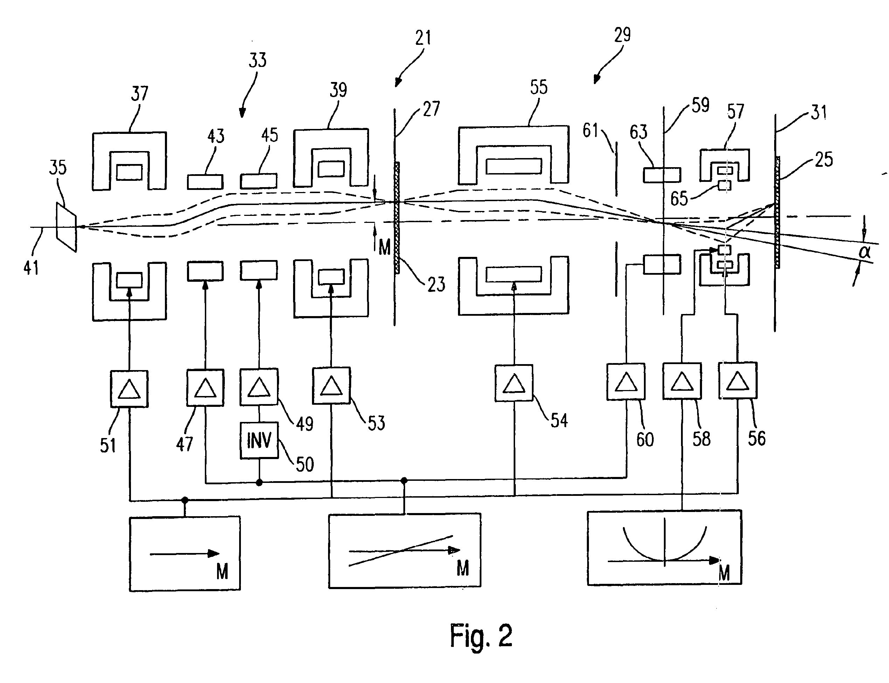

Eine in Figur 2 dargestellte Elektronenprojektionslithografieanordnung 21 dient dazu, eine auf einer Maske 23 definierte Struktur auf einen mit einer strahlungsempfindlichen Schicht versehenen Halbleiter-Wafer 25 abzubilden. Hierzu ist die wirksame Schicht der Maske 23 in einer Objektebene 27 einer Linsenanordnung 29 angeordnet, in deren Bildebene 31 die strahlungsempfindliche Schicht des Wafers 25 angeordnet ist.

Neben der Linsenanordnung 29 zur Abbildung der Maske 23 auf den Wafer 25 weist die Projektionslithografieanordnung 21 noch eine Beleuchtungsanordnung 33 zur Beleuchtung der Maske 23 auf. Die Beleuchtungsanordnung 33 umfasst eine in Figur 2 nicht dargestellte Elektronenquelle zur Ausleuchtung einer Strahlformungsblende 35, welche ein beleuchtetes Teilfeld der Maske 23 definiert. Die von der nicht dargestellten Elektronenquelle ausgeleuchtete Strahlformungsblende 35 wird hierzu mittels zweier fokussierender Linsen 37 und 39 in die Objektebene 27 der Linsenanordnung 29 abgebildet. Die beiden fokussierenden Linsen 37 und 39 sind bezüglich einer optischen Achse 41 der Projektionsanordnung 21 symmetrisch angeordnet. Das durch die ebenfalls zentral auf der optischen Achse 41 angeordnete Strahlformungsblende 35 definierte beleuchtete Teilfeld in der Objektebene 27 kann quer zu der Objektebene aus der optischen Achse 41 heraus verlagert werden, indem zwei Ablenkeinheiten 43 und 45 entsprechend angesteuert werden. Hierzu weisen die Ablenkeinheiten 43 und 45 entsprechende Treiber 47 und 49 auf, welche mit einer zur gewünschten Auslenkung M des Teilfelds von der optischen Achse 41 proportionalen Abhängigkeit angesteuert werden, wobei allerdings die Ansteuerung der beiden Treiber 47 und 49 mit jeweils umgekehrtem Vorzeichen erfolgt, wozu ein Inverter 50 vorgesehen ist. Die Ansteuerung der Fokussierlinsen 37 und 39 erfolgt über Treiber 51 und 53 unabhängig im Wesentlichen von der Auslenkung M.

Die Abbildung des beleuchteten Teilfelds von der Objektebene 27 der Linsenanordnung 29 in die Bildebene 31 derselben erfolgt im Wesentlichen durch eine Fokussierlinse 55 und eine weitere Fokussierlinse 57. Hierbei sind die Brennweiten der beiden Fokussierlinsen 55 und 57 sowie deren Abstände von der Objektebene 27 und der Bildebene 31 derart aufeinander abgestimmt, dass die Abbildung von der Objektebene 27 auf die Bildebene 31 um einen Faktor 1:4 verkleinernd erfolgt.

Ferner sind die Brennweiten und Abstände so abgestimmt, dass die Objektebene 27 durch die Fokussierlinse 55 zunächst in eine Zwischenbildebene 59 abgebildet wird, welche durch die Fokussierlinse 57 schließlich in die Bildebene 31 abgebildet wird.

Zur Einstellung der entsprechenden Brennweiten der Fokussierlinsen 55 und 57 sind einzeln einstellbare, von der Auslenkung M allerdings im Wesentlichen unabhängig angesteuerte Treiber 54 bzw. 56 vorgesehen.

In einer Beugungsebene der Fokussierlinse 55 ist ferner eine Lochblende 61 angeordnet, welche Elektronen absorbiert, die an einer möglicherweise stärker streuenden Struktur der Maske 23 gestreut wurden und deshalb die strahlungsempfindliche Schicht auf dem Wafer 25 nicht erreichen sollen, womit die gewünschte Abbildung der Strukturen der Maske auf das Substrat erzeugt wird.

Zur Kompensation von Abbildungsfehlern zwischen Objektebene 27 und Bildebene 31 ist eine sogenannte dynamische Fokusspule 65 vorgesehen, welche innerhalb der Fokussierlinse 57 angeordnet ist. Die dynamische Fokusspule 65 dient zur Kompensation eines Fokusfehlers und wird mittels eines Treibers 58 derart angesteuert, dass sich ihr Feld mit einer im Wesentlichen quadratischen Abhängigkeit von der Auslenkung des Teilfelds M ändert. Eine solche Kompensation eines Fokusfehlers in Abhängigkeit von der Auslenkung M des Teilfelds könnte auch mit den Fokussierlinsen 55 und 57 selbst erfolgen. Allerdings weisen diese Polschuhe auf und sind deshalb relativ träge, so dass die Kompensation durch die separate dynamische Fokusspule 65 präziser möglich ist.

Ferner ist zur Kompensation des Effekts einer Bildfeldwölbung bei der Abbildung durch die Fokussierlinen 55 und 57 in der Zwischenbildebene 59 eine Ablenklinseneinrichtung 63 vorgesehen, welche Strahlen, die durch diese hindurch verlaufen, um einen einstellbaren Winkel α ablenkt. Die Ablenklinseneinrichtung 63 wird dabei mittels eines Treibers 60 derart angesteuert, dass der Ablenkwinkel α sich im Wesentlichen proportional zur Auslenkung M des Teilfelds von der optischen Achse 59 ändert.

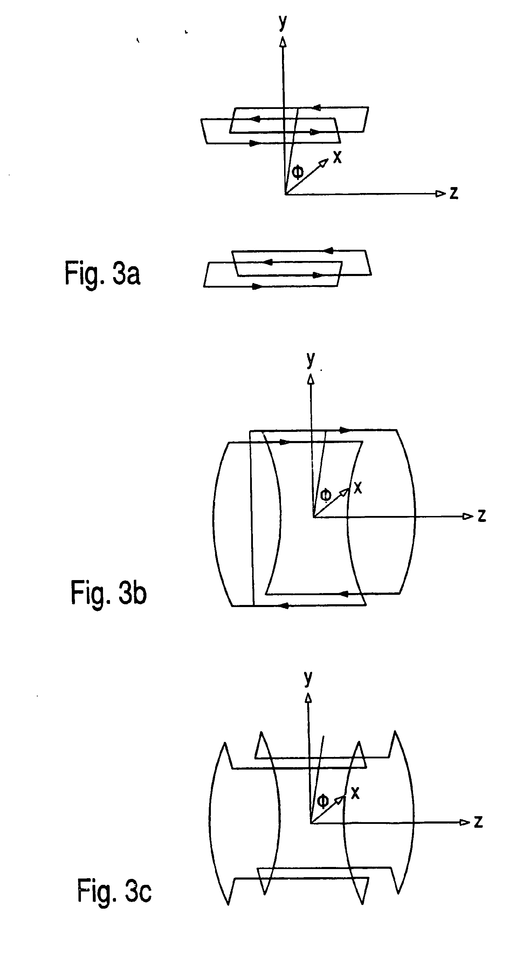

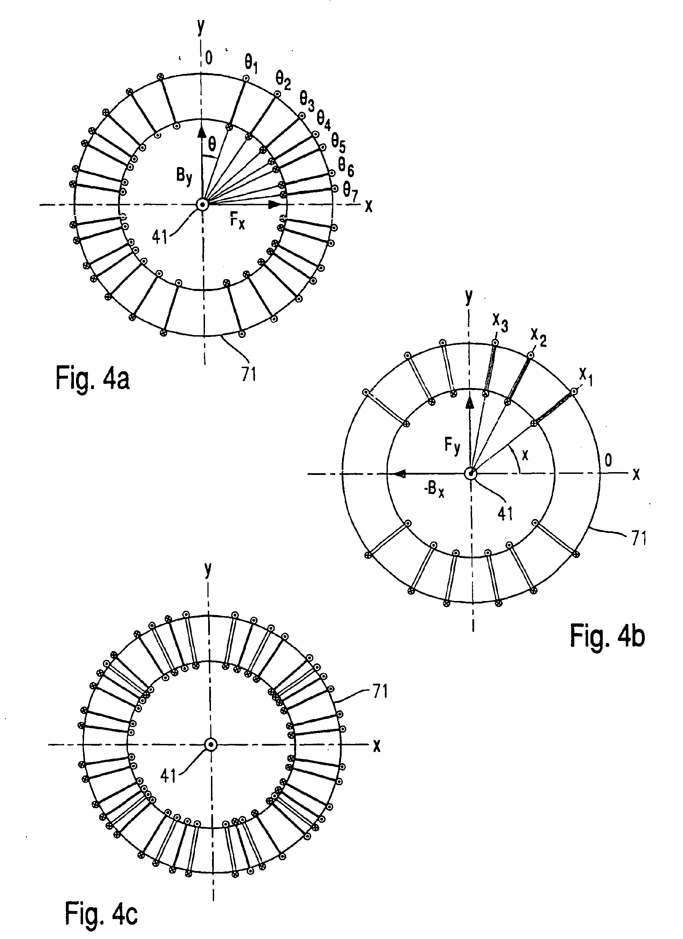

Mögliche Ausführungsformen für Windungen der Ablenklinseneinrichtung 63 sind in Figur 3 schematisch dargestellt. Hierbei zeigt Figur 3a die Ausführung von Windungen als Toroid-Spule, Figur 3b die Ausführung als Sattelspule und Figur 3c die Ausführung als Verbund-Sattelspule. Die einzelnen Spulenwindungen der Ablenklinseneinrichtung sind dabei auf einen oder mehrere Ferritringe 71 (vgl. Figur 4) aufgewickelt, die konzentrisch zur optischen Achse 41 angeordnet sind. Die Verteilung der einzelnen Windungen in Umfangsrichtung des Ferritrings 71 ist aus Figur 4 ersichtlich.

Figur 4a zeigt hierbei Windungen, die zur Erzeugung eines in eine Y-Richtung gerichteten magnetischen Dipolfelds By dienen, und Figur 4b zeigt Windungen, die zur Erzeugung eines hierzu orthogonalen Dipolfelds Bₓ dienen. In Figur 4c ist die Kombination der in den Figuren 4a und 4b gezeigten Windungen auf dem Ferritring 71 dargestellt.

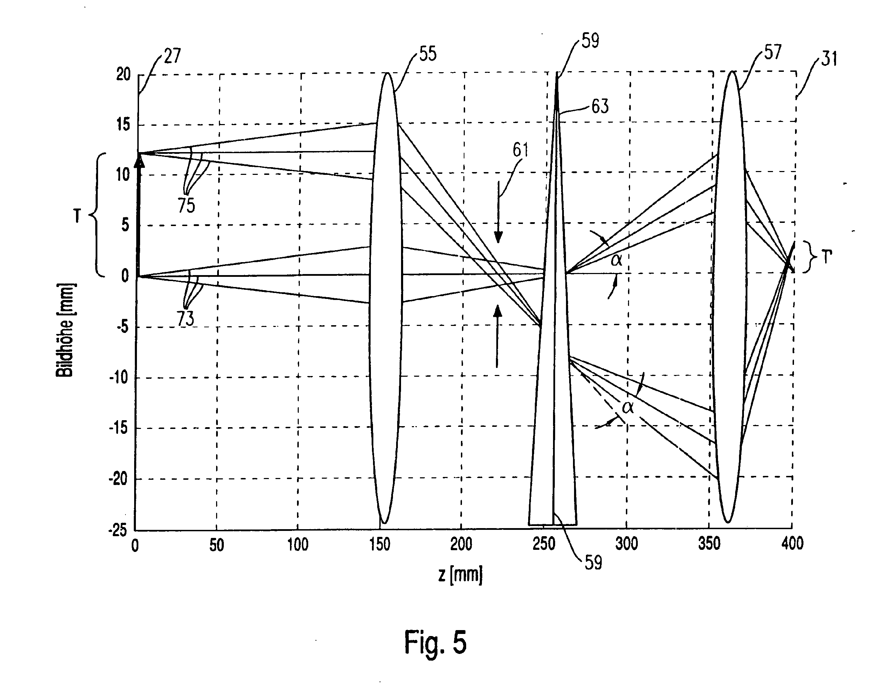

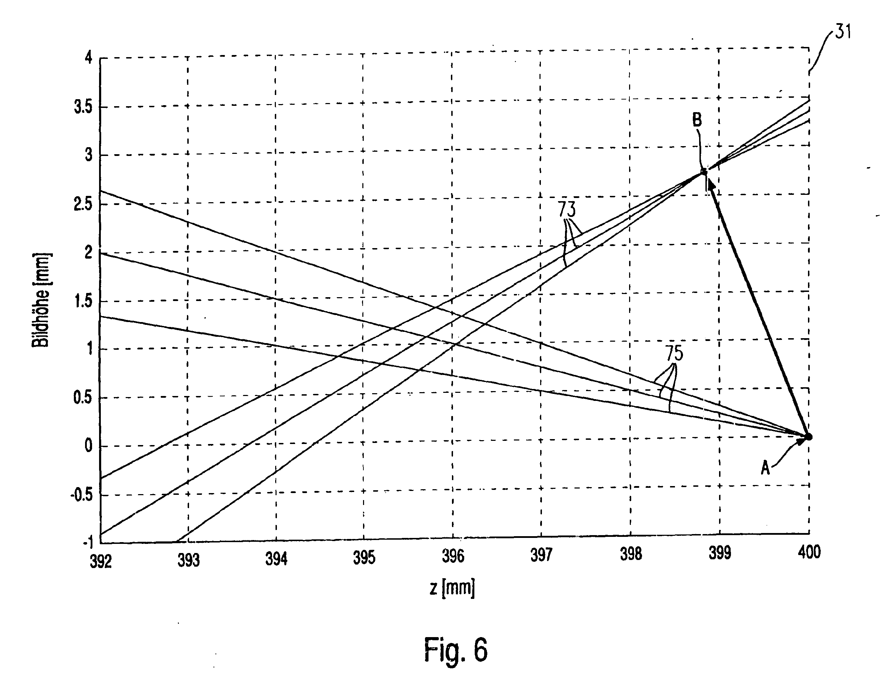

Die Wirkung der in der Zwischenbildebene 59 angeordneten Ablenklinse 63 wird nun unter Bezugnahme auf die Figuren 5 und 6 erläutert. Die Fokussierlinsen 55 und 57 sind in Figur 5 entsprechend ihrem optischen Analogon als Konvexlinsen dargestellt, während die Ablenklinse 59 entsprechend ihrem optischen Analogon in Figur 5 als Keil bzw. Prisma symbolisiert ist.

In Figur 5 ist die Objektebene 27 am Ort z = 0 angeordnet, die Fokussierlinse 55 weist eine Brennweite von 61,5 mm auf und ist am Ort z = 160 mm angeordnet. Damit ist die zu der Objektebene am Ort z = 0 korrespondierende Zwischenbildebene 59 der Fokussierlinse 55 am Ort z = 260 mm angeordnet. Die Fokussierlinse 57 weist eine Brennweite von 28,6 mm auf und ist am Ort z = 360 mm angeordnet, so dass durch die Fokussierlinse 57 die Zwischenbildebene 59 in die Bildebene 31 am Ort z = 400 abgebildet wird.

Es sei nun angenommen, dass die beiden Fokussierlinsen 55 und 57 abbildungsfehlerfreie Linsen sind, so dass die Objektebene 27 tatsächlich in die Bildebene 31 abgebildet wird. Ein Teilfeld T in der Objektebene 27 wird damit, bei abgeschalteter Ablenklinseneinrichtung 63 alleine durch die Fokussierlinsen 55 und 57 in ein Teilfeld T' in der Bildebene 31 abgebildet. In Figur 5 ist ein unteres Randstrahlenbünel 73 des Teilfelds T sowie ein oberes Randstrahlenbündel 75 desselben dargestellt.

Die Wirkung der Ablenklinseneinrichtung 63 auf die Strahlen 73 und 75 ist dabei derart, dass diese in der Zwischenbildebene 59 jeweils um einen Winkel α abgelenkt werden. Dies wiederum hat zur Folge, dass sich die Strahlenbündel 73, 75 nicht sämtlich in der Bildebene 31 treffen. Lediglich das Strahlenbündel 75, welches in der Objektebene 27 von der optischen Achse, also einer Bildhöhe von 0 mm ausging, vereinigt sich auf der Bildebene 31 (Schnittpunkt A in Figur 6). Das Strahlenbündel 73 hingegen, welches in der Objektebene 27 an einer Bildhöhe von 12 mm startete, vereinigt sich etwa 1 mm vor der Bildebene 31 in einem Schnittpunkt B in Figur 6.

Hieraus wird deutlich, dass die Wirkung der in der Zwischenbildebene 59 angeordneten Ablenklinseneinrichtung zu einer Verkippung des Teilbilds in der Bildebene 31 führt. Mit der in der Zwischenbildebene 59 angeordneten Ablenklinseneinrichtung 63 ist somit eine Möglichkeit geschaffen, ein gezieltes Kippen des Teilbilds in der Bildebene 31 herbeizuführen. Umgekehrt ist es damit aber auch möglich, ein durch Bildfehler der Linsenanordnung 29 erzeugtes und aus der Bildebene 31 herausgekipptes Bild derart zu verkippen, dass es in die Bildebene 31 zurückverlagert wird und damit schließlich die Abbildungsfehler der Fokussierlinsen 55 bzw. 57 wenigstens teilweise kompensiert werden.

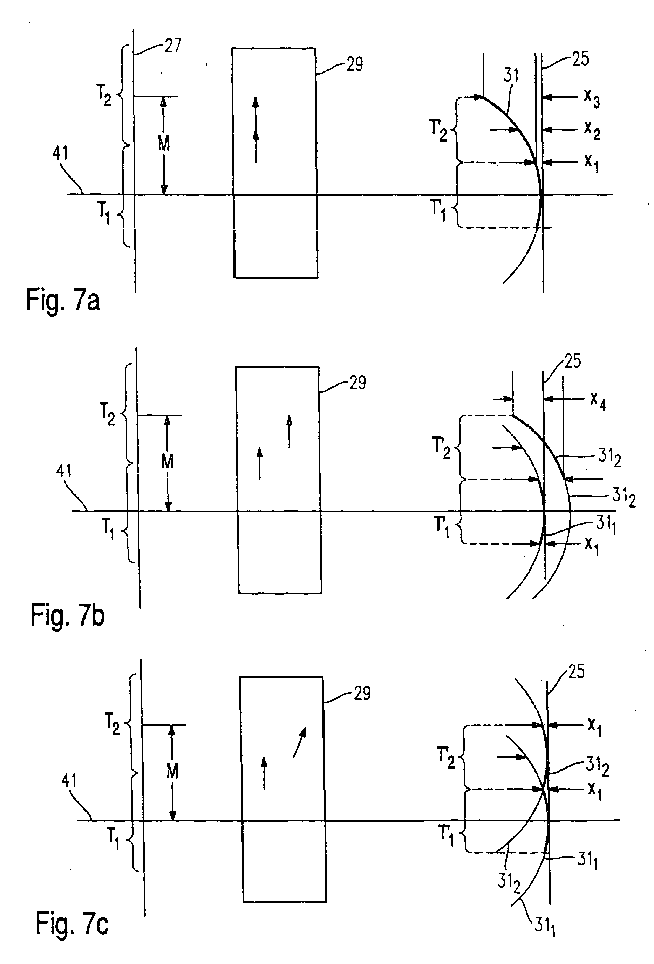

Dies ist nachfolgend im Zusammenhang mit Figur 7 erläutert. Dort ist die Linsenanordnung 29 lediglich schematisch als abbildendes System in Form eines Kastens dargestellt, welches eine als Ebene ausgebildete Objektfläche 27 in eine Bildfläche 31 abbildet. In Figur 7a ist die Ablenklinseneinrichtung 63 nicht in Betrieb, und Effekte der Bildfeldwölbung führen dazu, dass die Bildfläche nicht, wie die Objektfläche 27, in einer Ebene 25, welche beispielsweise die Oberfläche eines Wafers ist, angeordnet ist, sondern deutlich aus dieser herausgewölbt ist.

Ein zentral zur optischen Achse 41 angeordnetes Teilfeld T1 wird durch die Linsenanordnung 29 dabei derart auf die gewölbte Bildfläche 31 abgebildet, dass deren Zentrum auf dem Wafer 25 fokussiert ist, während ihr oberer Rand einen Abstand x1 von der Oberfläche des Wafers 25 entfernt fokussiert ist.

Ein mit seinem Zentrum um M versetzt von der optischen Achse 41 angeordnetes Teilfeld T2 wird in ein Teilfeld T2' abgebildet, dessen Zentrum eine Strecke x2 vor dem Wafer 25 fokussiert ist, und dessen Ränder um Strecken x1 bzw. x3 vor dem Wafer 25 fokussiert sind. Es ist ersichtlich, dass die Wölbung des Bildfelds 31 zu einer erheblichen Abbildungsunschärfe in der Ebene des Wafers 25 führt.

In Figur 7b ist eine erste Maßnahme zur Korrektur der Bildfeldwölbung dargestellt. Es wird dort das zentral zur optischen Achse 41 angeordnete Teilfeld T1 durch die Linsenanordnung 29 genauso in Richtung zu dem Wafer 25 abgebildet, wie dies in Zusammenhang mit Figur 7a erläutert wurde. Es wird somit das Teilfeld T1 in ein Teilfeld T1' auf einer Bildfläche 31₁ abgebildet, deren Zentrum auf dem Wafer 25 liegt. Ränder des Bildfelds T1' weisen somit einen Fokusfehler von x1 auf, wie dies ebenfalls in Figur 7a der Fall war.

Für die Abbildung des um den Betrag M von der optischen Achse 41 weg versetzten Teilfelds T2 stellt allerdings die dynamische Fokusspule 65 ein magnetisches fokussierendes Feld derart bereit, dass die Objektfläche 27 auf eine Bildfläche 31₂ abgebildet wird, welche gegenüber der Bildfläche 31₁ für das Teilfeld T1 derart verlagert ist, dass ein Zentrum des abgebildeten Teilfelds T2' den Wafer 25 schneidet bzw. auf diesen fokussiert ist. Damit tritt im Zentrum des abgebildeten Teilfelds T2' im Wesentlichen kein Fokussierfehler auf, während an dem oberen Rand des abgebildeten Teilfelds T2' der Fokussierfehler auf einen Wert x4 verringert wurde, der kleiner ist als der vergleichbare Fokussierfehler x3 der Figur 7a.

Der bei der Abbildung des Teilfelds T2 in das abgebildete Teilfeld T2' durch Zuschalten der dynamischen Fokusspule 65 bereits verringerte Bildfehler lässt sich nun noch weiter verringern, indem die Ablenklinseneinrichtung 63 in Betrieb genommen wird. Dies ist in Figur 7c erläutert. Auch in Figur 7c erfolgt die Abbildung des Teilfelds T1 ohne Einfluss der dynamischen Fokussierspule 65 und der Ablenklinseneinrichtung 63, wie dies auch in den Figuren 7a und 7b der Fall war. Allerdings erfolgt die Abbildung des Teilfelds T2, welches um den Betrag M aus der optischen Achse 41 heraus verlagert ist, derart, dass, wie in Figur 7b, die dynamische Fokusspule 65 den Fokus des Zentrums des abgebildeten Teilfelds T2' wieder auf die Oberfläche des Wafers 25 legt. Ferner wird durch eine geeignete Ansteuerung der Ablenklineneinrichtung 63 eine Verkippung der Bildfläche in eine Bildfläche 31₂ derart erzeugt, dass die Bildfläche 31₂ symmetrisch zum Zentrum des abgebildeten Teilfelds T2' auf dem Wafer 25 ausgerichtet ist. Damit ist ein Fokussierfehler an den Rändern des abgebildeten dezentralen Teilfelds T2' gleich dem Wert x1 des Abbildungsfehlers an den Rändern des abgebildeten zentralen Teilfelds T1'.

Dies bedeutet, dass auch mit Abstand von der optischen Achse 41 angeordnete Teilfelder mit einer Qualität auf den Wafer 25 abgebildet werden können, die mit einer Qualität der Abbildung nahe der optischen Achse vergleichbar ist.

Die gewählte Verkippung der Bildfläche führt dabei, in Zusammenwirkung mit einer entsprechenden Fokuskorrektur, dazu, dass die Bildfläche für ein abgebildetes Teilfeld besonders gut an eine Soll-Bildfläche, nämlich die Waferoberfläche, angenähert ist.

In einem scannenden System, in dem das beleuchtete Teilfeld gleichförmig über eine ebene Objektfläche bewegt wird, kann somit ebenfalls eine Abbildung auf eine ebene Bildfläche mit vergleichsweise geringen Abbildungsfehlern auf Grund von Bildfeldwölbungen erreicht werden, indem eine durch die Ablenklinseneinrichtung herbeigeführte Bildkippung mit einer zunehmenden Auslenkung des beleuchteten Teilfelds kontinuierlich erhöht wird. Insbesondere wird die Ablenklinseneinrichtung dabei derart angesteuert, dass sich deren Wirkung proportional zur Auslenkung des Teilfelds ändert. Einhergehend mit der Änderung der Wirkung der Ablenklinseneinrichtung wird dabei auch die Wirkung der ersten oder/und zweiten Fokussierlinseneinrichtung derart geändert, dass deren Fokus für das gerade belichtete Teilfeld mit der Soll-Bildfläche zusammenfällt. Die Änderung der Wirkung der ersten oder/und zweiten Fokussierlinseneinrichtung erfolgt dabei mit im Wesentlichen quadratischer Abhängigkeit von der Auslenkung des gerade belichteten Teilfelds.

In dem vorangehend beschriebenen Ausführungsbeispiel ist die Ablenklinseneinrichtung durch ein magnetisches Dipolfeld gebildet. Es gibt jedoch auch die Möglichkeit, ein elektrisches Dipolfeld oder jegliches andere Feld vorzusehen, dessen Wirkung auf einen Bereich um die durch die erste Fokussierlinseneinrichtung 51 definierte Zwischenbildebene zu einer Ablenkung der Strahlen bzw. Verkippung des Zwischenbilds führt.

Die erste bzw. zweite Fokussierlinseneinrichtung ist in dem vorangehend beschriebenen Ausführungsbeispiel als eine zur optischen Achse 41 achssymmetrische Magnetlinse mit Polschuhen beschrieben. Alternativ hierzu ist es jedoch auch möglich, die fokussierende Wirkung durch ein elektrostatisches Feld zu erzeugen.

Sowohl für elektrische wie auch magnetische fokussierende Felder ist es wesentlich, dass diese in dem Bereich des gerade beleuchteten Teilfeldes fokussierend wirken, während die Felder in Bereichen außerhalb des beleuchteten Teilfelds nicht unbedingt die fokussierende Wirkung aufweisen müssen.

Die vorangehend beschriebene Ausführungsform der erfindungsgemäßen Linsenanordnung ist in einem Elektronenprojektionslithografiesystem eingesetzt. Es ist jedoch auch möglich, die Linsenanordnung in einem System einzusetzen, welches nicht mit Elektronen sondern mit beispielsweise Ionen arbeitet. Die Linsenanordnung ist ferner in einem Verfahren zur Herstellung elektronischer Bauelemente sowie zur Herstellung anderer miniaturisierter Bauelemente einsetzbar, wobei die Abbildung von der Objektfläche in die Bildfläche der Belichtung einer teilchenempfindlichen Schicht in einem Lithografieschritt dient. Allerdings ist der Einsatz der Linsenanordnung nicht auf Lithografieschritte beschränkt, sondern immer dann möglich, wenn eine Objektfläche mit hoher Präzision teilchenoptisch in eine Bildfläche einer gewünschten Gestalt abzubilden ist.

## Patentansprüche

1. Linsenanordnung zur teilchenoptischen Abbildung eines in einer Objektfläche (27) anordenbaren abzubildenden Objekts (23) in eine Bildfläche (31), umfassend:
eine Beleuchtungsanordnung (33) zur Beleuchtung des in der Objektfläche (27) anordenbaren Objekts (23) mit abbildenden Teilchen,
eine erste Fokussierlinseneinrichtung (55) zur Bereitstellung eines auf die abbildenden Teilchen fokussierend wirkenden Feldes zur Abbildung des Objekts (23) von der Objektfläche (27) in eine Zwischenbildfläche (59),
eine zweite Fokussierlinseneinrichtung (57) zur Bereitstellung eines weiteren auf die abbildenden Teilchen fokussierend wirkenden Feldes, und
eine Ablenklinseneinrichtung (63) zur Bereitstellung eines auf die abbildenden Teilchen ablenkend wirkenden Feldes, wobei
die zweite Fokussierlinseneinrichtung (57) ausgebildet ist, um das in die Zwischenbildfläche (59) abgebildete Objekt (23) in die Bildfläche (31) abzubilden, **dadurch gekennzeichnet,**
**dass** die Ablenklinseneinrichtung (63) ausgebildet ist, um das auf die abbildenden Teilchen ablenkend wirkende Feld in einem Bereich der Zwischenbildfläche (59) bereitzustellen.

2. Linsenanordnung nach Anspruch 1, wobei das Feld der ersten oder/und zweiten Fokussierlinseneinrichtung (55) ein bezüglich einem Zentralstrahl eines Strahlenbündels (73) der abbildenden Teilchen im Wesentlichen achssymmetrisch ausgebildetes magnetisches oder/und elektrisches Feld umfasst.

3. Linsenanordnung nach Anspruch 1, wobei das Feld der ersten oder/und zweiten Fokussierlinseneinrichtung zwei bezüglich einem Zentralstrahl eines Strahlenbündels der abbildenden Teilchen mit axialem Abstand voneinander angeordnete magnetische oder/und elektrische Dipol- oder/und Quadrupol-Feldanordnungen umfasst.

4. Linsenanordnung nach einem der Ansprüche 1 bis 3, wobei das Feld der Ablenklinseneinrichtung (63) ein bezüglich einer gemeinsam mit einem Zentralstrahl eines Strahlenbündels der abbildenden Teilchen sich erstreckenden Ebene im Wesentlichen spiegelsymmetrisch ausgebildetes magnetisches Feld umfasst.

5. Linsenanordnung nach einem der Ansprüche 1 bis 4, wobei das Feld der Ablenklinseneinrichtung (63) ein quer zu einem Zentralstrahl eines Strahlenbündels der abbildenden Teilchen ausgerichtetes magnetisches oder/und elektrisches Dipolfeld umfasst.

6. Linsenanordnung nach einem der Ansprüche 1 bis 5, wobei in einer Beugungsebene (61) der ersten Fokussierlinseneinrichtung (55) oder/und der zweiten Fokussierlinseneinrichtung (57) eine Lochblende (61) vorgesehen ist.

7. Linsenanordnung nach einem der Ansprüche 1 bis 6, ferner umfassend eine erste Ansteuereinrichtung für die Ablenklinseneinrichtung (63) zur Einstellung einer Stärke von deren ablenkend wirkenden Feld und eine zweite Ansteuereinrichtung für die erste Fokussierlinseneinrichtung (55) oder/und die zweite Fokussierlinseneinrichtung (57) zur Einstellung einer Stärke von deren fokussierend wirkenden Feldern, wobei die erste Ansteuereinrichtung ausgebildet ist, um die Stärke des Feldes der Ablenklinseneinrichtung (63) mit einer im Wesentlichen proportionalen Abhängigkeit von einer externen Grösse (M) zu ändern und die zweite Ansteuereinrichtung ausgebildet ist, um die Stärke des Feldes der ersten bzw. zweiten Fokussierlinseneinrichtung (55), (57) mit einer im Wesentlichen quadratischen Abhängigkeit von der externen Grösse (M) zu ändern.

8. Linsenanordnung nach Anspruch 7, wobei die Linsenanordnung (29) zur Abbildung eines von einer optischen Achse (41) der Linsenanordnung (29) einen variablen Abstand (M) aufweisenden Teilfeldes (T) der Objektfläche (27) auf die Bildfläche (31) vorgesehen ist und wobei die externe Grösse den Abstand (M) des Teilfeldes (T) von der optischen Achse (41) umfasst.

9. Linsenanordnung nach Anspruch 8, wobei das Feld der Ablenklinseneinrichtung (63) verschiedene Strahlen der das Teilfeld (T) abbildenden Teilchenstrahlen (73, 75) um im Wesentlichen gleiche Winkel α ablenkt.

10. Linsenanordnung nach Anspruch 8 oder 9, wobei die Beleuchtungsanordnung (33) zur Beleuchtung lediglich eines Teilfeldes (T) der Objektfläche (27) ausgestaltet ist, und die Linsenanordnung ferner eine dritte Ansteuervorrichtung (47, 49) für die Beleuchtungsanordnung (33) umfasst, mittels der die Beleuchtungsanordnung (33) ansteuerbar ist, um den Abstand (M) des beleuchteten Teilfeldes (T) von der optischen Achse (41) zu ändern.

11. Linsenanordnung nach einem der Ansprüche 8 bis 10, wobei die Bildfläche (31) und die Objektfläche (27) jeweils eine vorbestimmte Sollgestalt aufweisen, wobei die zweite Ansteuervorrichtung ausgebildet ist, um die Stärke des Ablenkfeldes der ersten bzw. zweiten Fokussiereinrichtung derart zu ändern, dass ein zentraler Bereich des Teilfeldes (T) im Wesentlichen scharf auf die Bildfläche abgebildet wird, und wobei die erste Ansteuervorrichtung ausgebildet ist, um die Stärke des Ablenkfeldes der Ablenklinseneinrichtung derart zu ändern, dass auch Randbereiche des Teilfeldes im Wesentlichen scharf auf die Bildfläche abgebildet werden.

12. Linsenanordnung nach Anspruch 11, wobei die Gestalt der Objektfläche eine Ebene ist.

13. Linsenanordnung nach einem der Ansprüche 1 bis 12, wobei das ablenkend wirkende Feld der Ablenklinsenanordnung (63) dieses durchlaufende Teilchen in im Wesentlichen gleiche Richtungen ablenkt.

14. Verfahren zur Herstellung eines Bauelements, umfassend wenigstens einen photolithographischen Schritt, wobei der photolithographische Schritt das Übertragen eines durch eine Maske (23) definierten Musters auf ein teilchenempfindliches Substrat (25) mittels der Linsenanordnung (29) nach einem der Ansprüche 1 bis 13 umfasst, wobei die Maske (23) in der Objektfläche (27) und das Substrat (25) in der Bildfläche (31) angeordnet sind.

## Claims

1. A lens arrangement for the particle-optical imaging of an object (23), to be imaged and positionable in an object area (27), into an image area (31), comprising:
an illumination arrangement (33) for illuminating the object (23), positionable in the object area (27), with imaging particles,
a first focusing lens device (55) for providing a field having a focusing effect on the imaging particles for imaging the object (23) from the object area (27) into an intermediate image area (59),
a second focusing lens device (57) for providing a further field having a focusing effect on the imaging particles, and
a deflection lens device (63) for providing a field having a deflecting effect on the imaging particles, wherein the second focusing lens device (57) is configured to image the object (23), imaged in the intermediate image area, into the image area (31), **characterized in that** the deflection lens device (63) is configured to provide the field having a deflecting effect on the imaging particles in a region of the intermediate image area (59).

2. The lens arrangement according to claim 1, wherein the field of the first or/and the second focusing lens device (55) comprises a magnetic or/and electric field which is substantially axially symmetric in respect of a central beam of a beam bundle (73) of the imaging particles.

3. The lens arrangement according to claim 1, wherein the field of the first or/and the second focusing lens device comprises two magnetic or/and electric dipole or/and quadrupole field arrangements which are axially spaced apart from one another in respect of a central beam of a beam bundle of the imaging particles.

4. The lens arrangement according to one of claims 1 to 3, wherein the field of the deflection lens device (63) comprises a magnetic field which is substantially mirror-symmetric in respect of a plane jointly extending with a central beam of a beam bundle of the imaging particles.

5. The lens arrangement according to one of claims 1 to 4, wherein the field of the deflection lens device (63) comprises a magnetic or/and electric dipole field which is oriented transverse to a central beam of a beam bundle of the imaging particles.

6. The lens arrangement according to one of claims 1 to 5, wherein an aperture stop (61) is provided in a diffraction plane (61) of the first focusing lens device (55) or/and the second focusing lens device (57).

7. The lens arrangement according to one of claims 1 to 6, further comprising a first driving means for the deflection lens device (63) for adjusting a strength of the deflecting field thereof, and a second driving means for the first focusing lens device (55) or/and the second focusing lens device (57) for adjusting a strength of the focusing fields thereof, wherein the first driving means is configured to change the field strength of the deflection lens device (63) substantially proportionally dependent upon an external quantity (M) and the second driving means is configured to change the field strength of the first focusing lens device (55) and the second focusing lens device (57), respectively, substantially quadratically dependent upon the external quantity (M).

8. The lens arrangement according to claim 7, wherein the lens arrangement (29) is provided for imaging a subfield (T) of the object area (27) which is spaced apart from the optical axis (41) of the lens arrangement (29) by a variable distance (M) onto the image area (31), and wherein the external quantity comprises the distance (M) of the subfield (T) from the optical axis (41).

9. The lens arrangement according to claim 8, wherein the field of the deflection lens device (63) deflects different beams of the particle beams (73, 75) imaging the subfield (T) by substantially equal angles α.

10. The lens arrangement according to claim 8 or 9, wherein the illumination arrangement (33) is configured to illuminate merely a subfield (T) of the object area (27), and the lens arrangement further comprises a third driving means (47, 49) for the illumination arrangement (33) for driving the illumination arrangement (33) to vary the distance (M) of the illuminated subfield (T) from the optical axis (41).

11. The lens arrangement according to one of claims 8 to 10, wherein the image area (31) and the object area (27) each have a predetermined nominal shape, wherein the second driving means is configured to change the strength of the deflecting field of the first and the second focusing device, respectively, such that a central region of the subfield (T) is imaged substantially sharply onto the image area, and wherein the first driving means is configured to change the strength of the deflecting field of the deflection lens device such that also the peripheral regions of the subfield are imaged substantially sharply onto the image area.

12. The lens arrangement of claim 11, wherein the shape of the object area is that of a plane.

13. The lens arrangement according to one of claims 1 to 12, wherein the deflecting field of the deflection lens device (63) deflects particles passing therethrough in substantially identical directions.

14. Method for device manufacture, comprising at least one photolithographic step, wherein the photolithographic step comprises the transfer of a pattern defined by a mask (23) onto a particle-sensitive substrate (25) by means of the lens arrangement (29) according to one of claims 1 to 13, wherein the mask (23) is disposed in the object area (27) and the substrate (25) is disposed in the image area (31).

## Revendications

1. Assemblage de lentilles pour l'imagerie optique de particules d'un objet (23), devant être imagé et pouvant être disposé dans une surface d'objet (27), dans un champ d'image (31), comprenant :
un dispositif d'éclairage (33) pour éclairer l'objet (23) pouvant être disposé dans la surface d'objet (27) avec des particules à imager,
un premier dispositif de lentilles de focalisation (55) pour fournir un champ ayant un effet de focalisation sur les particules à imager pour imager l'objet (23) de la surface d'objet (27) dans un champ d'image intermédiaire (59),
un second dispositif de lentilles de focalisation (57) pour fournir un autre champ ayant un effet de focalisation sur les particules à imager, et
un dispositif de lentilles de déviation (63) pour fournir un champ ayant un effet de déviation sur les particules à imager, dans lequel
le second dispositif de lentilles de focalisation (57) est configuré pour imager l'objet (23) dans le champ d'image (31) imagé dans le champ d'image intermédiaire (59),
**caractérisé en ce que**
le dispositif de lentilles de déviation (63) est configuré pour fournir le champ ayant un effet de déviation sur les particules à imager dans une zone du champ d'image intermédiaire (59).

2. Assemblage de lentilles selon la revendication 1, dans lequel le champ du premier ou/et second dispositif de lentilles de focalisation (55) comprend un champ magnétique ou/et électrique conçu essentiellement asymétrique par rapport à un faisceau central d'un faisceau lumineux (73) des particules à imager.

3. Assemblage de lentilles selon la revendication 1, dans lequel le champ du premier ou/et second dispositif de lentilles de focalisation comprend deux dispositions de champs dipolaires ou/et quadrupolaires magnétiques ou/et électriques disposées à une distance axiale les unes des autres par rapport à un faisceau central d'un faisceau lumineux des particules à imager.

4. Assemblage de lentilles selon une des revendications 1 à 3, dans lequel le champ du dispositif de lentilles de déviation (63) comprend un champ magnétique conçu essentiellement symétrique en miroir par rapport à un plan s'étendant conjointement avec un faisceau central d'un faisceau lumineux des particules à imager.

5. Assemblage de lentilles selon une des revendications 1 à 4, dans lequel le champ du dispositif de lentilles de déviation (63) comprend un champ dipolaire magnétique ou/et électrique aligné transversalement sur un faisceau central d'un faisceau lumineux des particules à imager.

6. Assemblage de lentilles selon une des revendications 1 à 5, dans lequel un diaphragme d'ouverture (61) est prévu dans un plan de diffraction (61) du premier dispositif de lentilles de focalisation (55) ou/et du second dispositif de lentilles de focalisation (57).

7. Assemblage de lentilles selon une des revendications 1 à 6, comprenant en outre un premier système de commande pour le dispositif de lentilles de déviation (63) en vue de régler une puissance du champ ayant un effet de déviation de celui-ci, et un deuxième système de commande pour le premier dispositif de lentilles de focalisation (55) ou/et le second dispositif de lentilles de focalisation (57) en vue de régler une puissance des champs ayant un effet de focalisation de celui-ci, dans lesquels le premier système de commande est configuré pour modifier la puissance du champ du dispositif de lentilles de déviation (63) de manière sensiblement proportionnellement dépendante d'une grandeur externe (M), et le deuxième système de commande est configuré pour modifier la puissance du champ du premier et/ou du second dispositif de lentilles de focalisation (55), (57) de manière sensiblement quadratiquement dépendante de la grandeur externe (M).

8. Assemblage de lentilles selon la revendication 7, dans lequel l'assemblage de lentilles (29) est prévu pour imager un champ partiel (T), présentant une distance (M) variable par rapport à un axe optique (41) de l'assemblage de lentilles (29), de la surface d'objet (27) sur le champ d'image (31), et dans lequel la grandeur externe comprend la distance (M) entre le champ partiel (T) et l'axe optique (41).

9. Assemblage de lentilles selon la revendication 8, dans lequel le champ du dispositif de lentilles de déviation (63) dévie différents faisceaux des faisceaux de particules (73, 75) représentant le champ partiel (T) à des angles α sensiblement égaux.

10. Assemblage de lentilles selon la revendication 8 ou 9, dans lequel le dispositif d'éclairage (33) est conçu pour éclairer uniquement un champ partiel (T) de la surface d'objet (27), et l'assemblage de lentilles comprend en outre un troisième système de commande (47, 49) pour le dispositif d'éclairage (33), au moyen duquel le dispositif d'éclairage (33) peut être commandé, afin de modifier la distance (M) du champ partiel (T) éclairé par rapport à l'axe optique (41).

11. Assemblage de lentilles selon une des revendications 8 à 10, dans lequel le champ d'image (31) et la surface d'objet (27) présentent respectivement une forme nominale prédéterminée, dans lequel le deuxième système de commande est configuré pour modifier la puissance du champ de déviation du premier et/ou second dispositif de focalisation, de sorte qu'une zone centrale du champ partiel (T) est imagée sensiblement nettement sur le champ d'image, et dans lequel le premier système de commande est configuré pour modifier la puissance du champ de déviation du dispositif de lentilles de déviation, de sorte que des zones périphériques du champ partiel sont également imagées sensiblement nettement sur la surface d'image.

12. Assemblage de lentilles selon la revendication 11, dans lequel la forme de la surface d'objet est celle d'un plan.

13. Assemblage de lentilles selon une des revendications 1 à 12, dans lequel le champ ayant un effet de déviation du dispositif de lentilles de déviation (63) dévie cette particule de passage dans des directions essentiellement identiques.

14. Procédé de fabrication d'un composant, comprenant au moins une étape photolithographique, dans laquelle l'étape photolithographique comprend le transfert d'un modèle défini par un masque (23) sur un substrat (25) sensible aux particules au moyen de l'assemblage de lentilles (29) selon une des revendications 1 à 13, dans lequel le masque (23) est disposé dans la surface d'objet (27) et le substrat (25) est disposé dans le champ d'image (31).
